# EUROPEAN PATENT APPLICATION

(11) **EP 4 693 390 A1**
(43) Date of publication of application: **11.02.2026**
(21) Application number: 24780899.1
(22) Date of filing: 29.03.2024
(51) Int. Cl.: H01L 23/13

(54) **SEMICONDUCTOR DEVICE SUBSTRATE AND METHOD FOR PRODUCING SEMICONDUCTOR DEVICE SUBSTRATE**

(30) Priority: 31.03.2023 WO PCT/JP2023/013738
(71) Applicant: NGK Insulators, Ltd., Nagoya-shi, Aichi 467-8530 (JP)
(72) Inventor: KAKU, Takeshi, Nagoya-shi, Aichi 467-8530 (JP); MASUDA, Izumi, Nagoya-shi, Aichi 467-8530 (JP); EBIGASE, Takashi, Nagoya-shi, Aichi 467-8530 (JP)
(74) Representative: Mewburn Ellis LLP
(86) International application number: PCT/JP2024/013282
(87) International publication number: WO 2024/204805

(57) **Abstract**

A semiconductor device substrate according to the present invention includes a silicon nitride ceramic substrate including a first surface and a second surface, a bonding layer disposed on the first surface and the second surface, and a copper plate disposed on the bonding layer, wherein the copper plate has a region in which an average crystal grain size of copper increases as a distance from an interface between the bonding layer and the copper plate increases, in which the average crystal grain size of copper at a first position separated from the interface by 20 µm is 25 µm or more and less than 100 µm, and the average crystal grain size of copper at a second position separated from the interface by 250 µm is 100 µm or more.

## Description

### Technical Field

The present invention relates to a semiconductor device substrate and a method for producing a semiconductor device substrate.

### Background Art

As a semiconductor device substrate used for a power transistor module or the like, a substrate including a copper plate disposed on a surface of a silicon nitride ceramic substrate with a bonding agent interposed between the copper plate and the silicon nitride ceramic substrate is known (for example, PTL 1).

### Citation List

### Patent Literature

PTL 1: Japanese Patent Laid-open Publication No. 2022-173209

### Summary of Invention

### Technical Problem

The semiconductor device substrate has a problem of durability in a hot-cold cycle, and there has been a demand for a semiconductor device substrate capable of suppressing peeling of a copper plate even under such an environment. The present invention has been made to solve this problem, and an object of the present invention is to provide a semiconductor device substrate capable of suppressing peeling of a copper plate even under a hot-cold cycle and a method for producing the semiconductor device substrate.

### Solution to Problem

Item 1. A semiconductor device substrate including:
a ceramic substrate including a first surface and a second surface;
a bonding layer disposed on the first surface and the second surface; and
a copper plate disposed on the bonding layer,
in which
the copper plate has a thickness of 0.3 mm or more, and
the copper plate has a region in which an average crystal grain size of copper increases as a distance from an interface between the bonding layer and the copper plate increases, in which the average crystal grain size of copper at a first position separated from the interface by 20 µm is 25 µm or more and less than 100 µm, and the average crystal grain size of copper at a second position separated from the interface by 250 µm is 100 µm or more.

Item 2. The semiconductor device substrate according to Item 1, wherein, in the copper plate, the average crystal grain size of copper at the second position is 100 µm or more and 600 µm or less.

Item 3. The semiconductor device substrate according to Item 1 or 2, wherein, in the copper plate, the average crystal grain size of copper at a third position separated from the interface by 100 µm is 50 µm or more and less than 150 µm.

Item 4. The semiconductor device substrate according to any one of Items 1 to 3, wherein the copper plate is formed of oxygen-free copper.

Item 5. A method for producing a semiconductor device substrate, the method including:
a first step of preparing a ceramic substrate including a first surface and a second surface;
a second step of forming a brazing material layer on the first surface and the second surface;
a third step of disposing a copper plate on the brazing material layer to obtain an intermediate product including the ceramic substrate, the brazing material layer, and the copper plate; and
a fourth step of disposing the intermediate product in a furnace and performing a heating and pressurizing treatment,
in which, in the fourth step, after a temperature of the intermediate product is increased to 800 to 900°C, the intermediate product is cooled to a softening point of copper constituting the copper plate at a first average cooling rate of 2.8 to 12°C/min in at least a part of the fourth step.

Item 6. The method for producing a semiconductor device substrate according to Item 5, wherein, in the fourth step, after the intermediate product is cooled to the softening point, the intermediate product is cooled at a second average cooling rate lower than the first average cooling rate.

Item 7. The method for producing a semiconductor device substrate according to Item 5 or 6, wherein, in the fourth step, a pressure in the heating and pressurizing treatment is 0.2 to 22 MPa.

Item 8. The method for producing a semiconductor device substrate according to any one of Items 5 to 7, wherein cooling is performed in an inert gas atmosphere in at least a part of the fourth step.

Item 9. The semiconductor device substrate according to any one of Items 5 to 8, wherein the copper plate is formed of oxygen-free copper in the fourth step. Advantageous Effects of Invention

The present invention can obtain a bonded substrate having high hot-cold cycle durability, in which peeling of a copper plate due to a temperature change can be suppressed.

### Brief Description of Drawings

[Fig. 1] Fig. 1 is a sectional view showing an embodiment of a semiconductor device including a semiconductor device substrate according to the present invention.
[Fig. 2] Fig. 2 is a sectional view showing an interface between a copper plate and a bonding layer.
[Fig. 3] Fig. 3 is a flowchart showing a method for producing a semiconductor device substrate.
[Fig. 4] Fig. 4 is a sectional view showing a step for producing the semiconductor device substrate.
[Fig. 5] Fig. 5 is a sectional view showing a step for producing the semiconductor device substrate.
[Fig. 6] Fig. 6 is a sectional view showing a step for producing the semiconductor device substrate.
[Fig. 7] Fig. 7 is a temperature profile in a step for producing the semiconductor device substrate.
[Fig. 8] Fig. 8 is a graph showing a schematic tendency showing a relationship between stress when a force acts in a direction of peeling off a plate from a bonding layer and a distance in a planar direction from an end portion of a circuit pattern.
[Fig. 9] Fig. 9 is a sectional view describing the horizontal axis of Fig. 8.

### Description of Embodiments

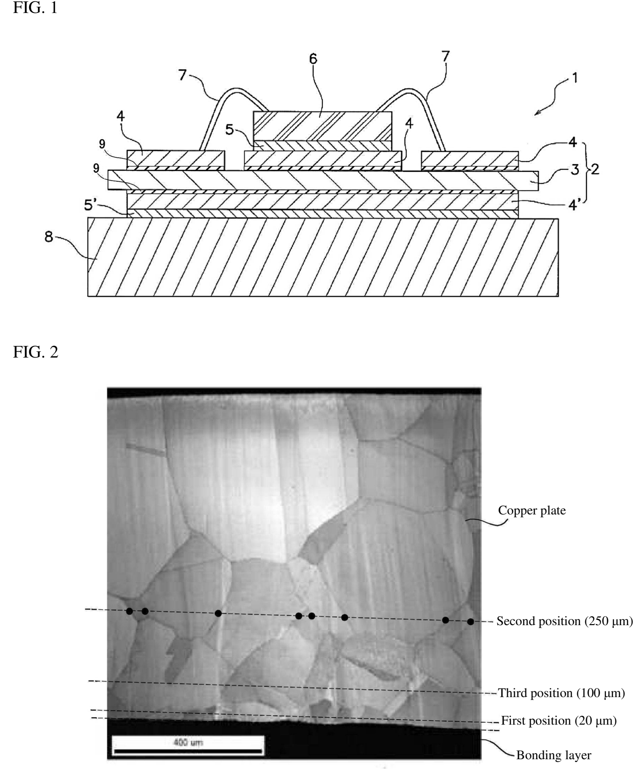

Hereinafter, an embodiment of a semiconductor device substrate according to the present invention will be described with reference to the drawings. Fig. 1 is a sectional view showing an example of a semiconductor device including a semiconductor device substrate according to the present embodiment.

### <1. Outline of semiconductor device>

The semiconductor device according to the present embodiment is used as a power module in various electronic devices such as a smartphone, a personal computer, a large major appliance, a railway, an electric vehicle, power generation (wind power generation, solar power generation, fuel cell, etc.), an air conditioner, an industrial robot, a business elevator, a household microwave oven, an IH electric rice cooker, and a UPS (uninterruptible power supply).

As shown in Fig. 1, a semiconductor device 1 according to the present embodiment includes a semiconductor device substrate 2, a first bonding material 5, a second bonding material 5', a semiconductor chip 6, a bonding wire 7, and a heat sink 8.

The semiconductor device substrate 2 includes a plate-like ceramic substrate 3 that is an insulator, a first copper plate 4 bonded to an upper surface (first surface) of the ceramic substrate 3 via a bonding layer 9, and a second copper plate 4' bonded to a lower surface (second surface) of the ceramic substrate 3 via the bonding layer 9. As the ceramic substrate 3, for example, an aluminum oxide substrate, an aluminum nitride substrate, or silicon nitride can be used.

The bonding layer 9 can contain an active metal. The active metal may be, for example, at least one active metal selected from the group consisting of titanium and zirconium. Alternatively, the bonding layer 9 may contain a metal other than the active metal. The metal other than the active metal contained in the bonding layer 9 is, for example, at least one metal selected from the group consisting of silver, copper, indium, and tin. The bonding layer 9 may contain nitrogen and/or silicon supplied from the ceramic substrate 3, and the supplied nitrogen and/or silicon may form a compound with the active metal. The bonding layer 13 may further contain copper supplied from the copper plates 12.

The first copper plate 4 is patterned to form a transmission circuit. On the other hand, the second copper plate 4' is formed in a flat plate shape. The copper plates 4 and 4' may be formed of oxygen-free copper, for example.

The semiconductor chip 6 is bonded to the upper surface of the semiconductor device substrate 2, that is, a part of the upper surface of the first copper plate 4 via the first bonding material 5. The semiconductor chip 6 and the first copper plate 4 are connected by the bonding wire 7.

The heat sink 8 is bonded to the lower surface of the semiconductor device substrate 2, that is, the lower surface of the second copper plate 4' via the second bonding material 5. The heat sink 8 is a known heat sink and may be formed of metal such as copper, for example.

The thicknesses of the ceramic substrate 3, the copper plates 4 and 4', and the bonding layer 9 are not particularly limited, but for example, the thickness of the ceramic substrate is preferably 0.2 to 0.5 mm, the thickness of the copper plate is preferably 0.3 to 2 mm, more preferably 0.5 to 1.5 mm, and particularly preferably 0.7 to 1.3 mm. The thickness of the bonding layer is preferably 0.1 to 20 µm.

### <2. Characteristics of semiconductor device substrate>

As shown in Fig. 2, the semiconductor device substrate 2 according to the present embodiment is characterized in that it has a region where the average crystal grain size of copper increases from the interface between the bonding layer 9 and each of the copper plates 4 and 4' along a thickness direction of each of the copper plates 4 and 4'. The profile of the average crystal grain size is configured as follows.
(1) In the copper plates 4 and 4', the average crystal grain size of copper at a first position separated by 20 µm in the thickness direction from the interface with the bonding layer 9 is 25 µm or more and less than 100 µm.
(2) In the copper plates 4 and 4', the average crystal grain size of copper at a second position separated by 250 µm in the thickness direction from the interface with the bonding layer 9 is 100 µm or more.
   In (2), the upper limit of the average crystal grain size is preferably 600 µm. In addition, it is preferable to define the following (3).
(3) In the copper plates 4 and 4', the average crystal grain size of copper at a third position separated by 100 µm in the thickness direction from the interface with the bonding layer 9 is 50 µm or more and less than 150 µm.

In the present embodiment, as the distance from the interface increases, the average crystal grain size of copper increases at least in the region up to 250 µm from the interface, it is sufficient that such a tendency is exhibited at least in the region up to 250 µm from the interface.

The average crystal grain size can be calculated as follows. First, select a region where a length of 10 mm or more can be secured on the surfaces of the copper plates 4 and 4' of the semiconductor device substrate 2. That is, select a region on the copper plates 4 and 4' that is not divided by patterning and in which a length of 10 mm or more can be secured. Next, select a length of 10 mm, and cut the semiconductor device substrate 2 so that the section including the midpoint of the length is exposed. Subsequently, polish the cut surface through wide area cross section polishing.

Next, perform EBSD analysis on the polished section to acquire an image. Then, enlarge the acquired image 50 times. Subsequently, count the number of intersections between reference lines 1 to 3 having a length of 1 mm and copper crystal grain boundaries, and divide the reference line length by the intersections to calculate the average crystal grain size. Fig. 2 is an example thereof, and the black circles attached on the reference line 2 are the intersections. In this example, since there are 8 intersections on the reference line 2, the average crystal grain size is 1000 µm/8 = 125 µm.

The above measurement method and measurement results can be applied to either a semiconductor device substrate in which the copper plates 4 and 4' are patterned as shown in Fig. 1, or a semiconductor device substrate in which patterning is not performed.

### <3. Method for producing semiconductor device substrate>

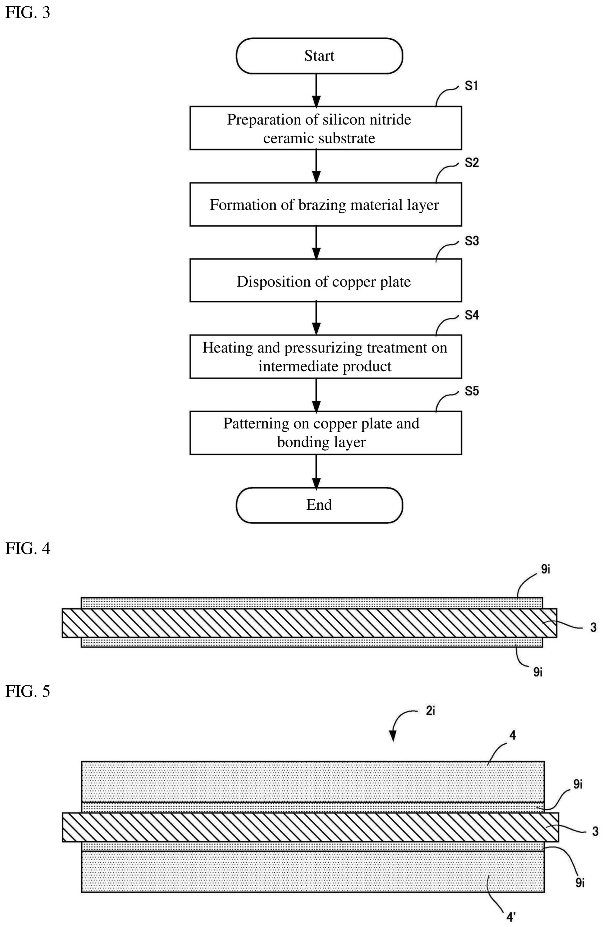

Next, a method for producing a semiconductor device substrate will be described. Fig. 3 is a flowchart showing a method for producing the semiconductor device substrate according to the present embodiment. Figs. 4, 5, and 6 are sectional views schematically showing an intermediate product obtained in the course of producing the semiconductor device substrate.

First, prepare the ceramic substrate 3 (step S1). Next, as shown in Fig. 4, form a brazing material layer 9i on the upper surface and the lower surface of the ceramic substrate 3 (step S1). At this point, prepare a paste containing an active metal brazing material, a binder, and a solvent as the brazing material layer 9i. The paste may further contain a dispersant, an antifoaming agent, and the like. Subsequently, perform screen printing of the prepared paste on the upper surface and the lower surface of the ceramic substrate 3. A screen-printed film is thus formed on each surface of the ceramic substrate 3. Subsequently, volatilize the solvent contained in the formed screen-printed film. This causes the screen-printed film to change to the brazing material layer 9i (step S2). The brazing material layer 9i contains the active metal brazing material and the binder. However, the brazing material layer 9i may be formed by a method different from this method.

The active metal brazing material contains a hydrogenated active metal powder and a metal powder. The hydrogenated active metal powder includes a hydrogenated product of at least one active metal selected from the group consisting of titanium and zirconium. The metal powder includes silver. The metal powder may include a metal other than silver. The metal other than silver is at least one metal selected from the group consisting of copper, indium, and tin. When the active metal brazing material contains at least one metal selected from the group consisting of copper, indium, and tin, the melting point of the active metal brazing material decreases.

The active metal brazing material is desirably made of powder having an average particle diameter of 0.1 µm or more and 20 µm or less. The average particle diameter can be obtained by measuring a particle size distribution with a commercially available laser diffraction type particle size distribution measuring apparatus, and calculating D50 (median diameter) from the measured particle size distribution. When the active metal brazing material is made of powder having such a small average particle diameter, the brazing material layer 9i can be thinned.

The brazing material layer 9i desirably has a thickness of 0.1 µm or more and 20 µm or less, and more desirably has a thickness of 0.1 µm or more and 5 µm or less.

Next, as shown in Fig. 5, dispose the copper plates 4 and 4' on the formed brazing material layer 9i (step S3). An intermediate product 2i including the ceramic substrate 3, the copper plates 4 and 4', and the brazing material layer 9i is thus obtained.

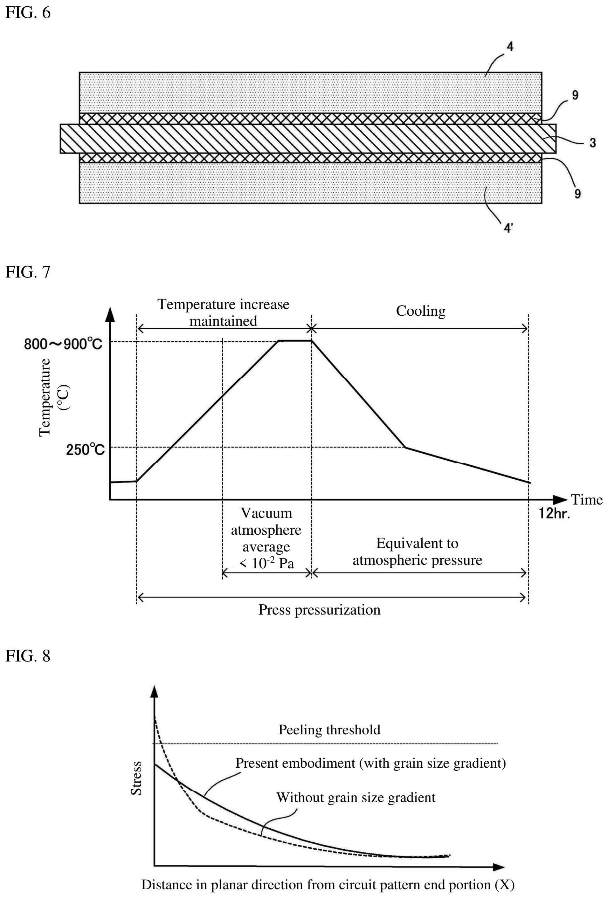

Subsequently, place the obtained intermediate product 2i in a heating furnace and perform a heating and pressurizing treatment (step S4). The bonding layer 9 is thus generated as illustrated in Fig. 6. As a result, the semiconductor device substrate 2 including the ceramic substrate 3, the copper plates 4 and 4', and the bonding layer 9 illustrated in Fig. 6 is obtained. The copper plates 4 and 4' are bonded to the ceramic substrate 3 by the bonding layer 9.

When the heating and pressurizing treatment is performed on the intermediate product 2i, heating is performed according to the temperature profile as shown in Fig. 7. As shown in Fig. 7, the temperature inside the furnace is increased so that the temperature of the intermediate product 1i becomes 800 to 900°C at a maximum (hereinafter referred to as upper limit temperature) under a vacuum atmosphere. The rate of temperature increase at this time can be, for example, 2 to 10 °C/min. In this process, the vacuum atmosphere in the furnace is adjusted to 10⁻² Pa or less in a bonding layer formation temperature region, that is, a time region from when the temperature reaches approximately 750°C or more until cooling starts. The intermediate product 2i is pressurized during the temperature increasing process and until the cooling completion. At this time, the surface pressure applied to the intermediate product 2i can be adjusted to, for example, 0.2 Pa to 22 MPa. The ceramic substrate 3, the brazing material layer 9i, and the copper plates 4 and 4' are reliably brought into contact with each other through pressurization, they can react with each other, and thus the bonding layer 9 can be formed.

Next, maintain the state in which the temperature of the intermediate product 2i is 800 to 900°C for a predetermined time (for example, 15 to 120 minutes), and then cool the intermediate product 2i. As a cooling method, for example, a method of injecting an inert gas such as nitrogen into the furnace and lowering the temperature in an inert gas atmosphere or a cooling method in a vacuum atmosphere can be applied. In the cooling in an inert gas atmosphere, the pressure is preferably equal to or higher than atmospheric pressure. Fig. 7 shows a profile in the case of cooling with an inert gas such as nitrogen.

In the process of cooling the intermediate product 2i, the intermediate product 2i is rapidly cooled from 800 to 900°C to the softening point of copper at a first average cooling rate of 2.8 to 12°C/min (preferably 5.0 to 9.0°C/min). After cooling to the softening point of copper, cooling is performed at a second average cooling rate lower than the first average cooling rate. The second average cooling rate can be, for example, 1.5 to 2.8°C/min. The softening point of copper depends on the material of copper, but is about 200 to 300°C (250°C as an example in Fig. 7).

Next, perform patterning on the copper plate 4 and the bonding layer 9 by an etching method or the like. The copper plate 4 thus changes to a patterned copper plate 4 illustrated in Fig. 1. The bonding layer 9 also changes to a patterned bonding layer 13 illustrated in Fig. 1.

### <4. Features>

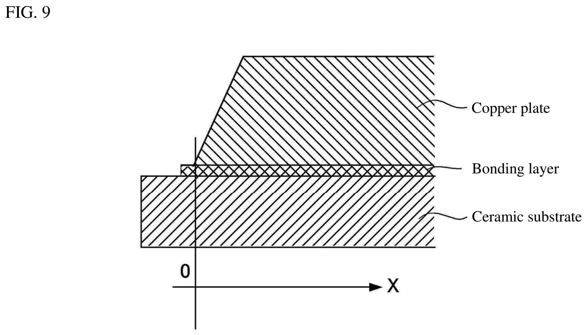

As described above, in the present embodiment, there is a region where the average crystal grain size of copper increases from the interface between the bonding layer 9 and each of the copper plates 4 and 4' along the thickness direction of the copper plates 4 and 4', and in particular, the above (1) and (2) are satisfied, thus peeling of the copper plates 4 and 4' can be suppressed. As in the above (1), when the average crystal grain size at the first position is small, peeling is easily suppressed. This point will be described with reference to Figs. 8 and 9.

Fig. 8 shows a stress distribution generated at the bonding interface during a hot-cold cycle treatment. Fig. 9 is a diagram describing the horizontal axis of Fig. 8. During the hot-cold cycle, a high stress is generated at the bonding interface between the copper 4 and 4' and the ceramic substrate 3 because of a difference in thermal expansion. As shown in Fig. 8, when the copper plates 4 and 4' have a gradient that increases the average crystal grain size of copper, the force is dispersed, and the peak value of the stress generated at the interface decreases. Thus, the peak value of the stress becomes lower than the threshold value at which peeling occurs, and peeling can be suppressed.

On the other hand, when the cooling rate is low, the average crystal grain size tends to be substantially the same or the average crystal grain size tends to increase in the thickness direction.

As described above, when the temperature of the intermediate product is increased to 800 to 900°C and then cooled to the softening point at the first average cooling rate of 2.8 to 12°C/min, a gradient of the average crystal grain size of copper can be formed in the copper plate. This is because cooling at a temperature equal to or higher than the softening point causes the crystal of copper to easily move, and the crystal grain size can be controlled. Thus, it is possible to produce a semiconductor device substrate capable of suppressing peeling of copper as described above. Examples

Hereinafter, Examples of the present invention will be described. The present invention is not limited to the following Examples.

### <1. Production of semiconductor device substrate>

A silicon nitride ceramic substrate having a thickness of 0.32 mm and a copper plate having a thickness of 0.8 mm were prepared. A brazing material containing an active metal brazing material containing 40 wt% or more and 95 wt% or less of silver and titanium hydride, the brazing material having a thickness of 0.1 µm or more and 20 µm or less, was also prepared. Then, this brazing material was applied to the upper and lower surfaces of the silicon nitride ceramic substrate by screen printing, and a copper plate formed of oxygen-free copper as an example was disposed thereon to form an intermediate product. The softening point of this oxygen-free copper was 250°C.

This intermediate product was then placed in a furnace and heated according to the temperature profile shown in Fig. 7. In the temperature increasing step, the temperature was increased to about 850°C at about 5°C/min, and pressurization was performed so that the pressure becomes about 20 MPa at the maximum temperature. Thereafter, cooling was performed at a cooling rate shown in Tables 1 to 4, and when the temperature was lowered to about 250°C, slow cooling was performed to normal temperature. Semiconductor device substrates according to Examples 1 to 9 and Comparative Examples 1 to 3 were thus completed. That is, in Examples, three semiconductor device substrates were produced at one cooling rate. In these semiconductor device substrates, the copper plate is not patterned.

### <2. Evaluation>

For the semiconductor device substrates according to Examples 1 to 9 and Comparative Examples 1 to 3, the average crystal grain size of copper at the first to third positions described above was measured. The results are as shown in Tables 1 to 4. The measurement conditions are as described above.

**[Table 1]**

| Position | Cooling rate °C/min | 2.8 | | | | | |
|---|---|---|---|---|---|---|---|
| | | Example 1 | | Example 2 | | Example 3 | |
| 2 | Grain size/Number of intersections um/point | 125 | 8 | 350 | 3 | 600 | 2 |
| 3 | | 100 | 10 | 140 | 7 | 145 | 7 |
| 1 | | 90 | 11 | 50 | 20 | 95 | 11 |

**[Table 2]**

| Position | Cooling rate °C/min | 6 | | | | | |
|---|---|---|---|---|---|---|---|
| | | Example 4 | | Example 5 | | Example 6 | |
| 2 | Grain size/Number of intersections um/point | 125 | 8 | 250 | 4 | 500 | 2 |
| 3 | | 66.7 | 15 | 125 | 8 | 125 | 8 |
| 1 | | 50 | 20 | 45 | 22 | 85 | 12 |

**[Table 3]**

| Position | Cooling rate °C/min | 12 | | | | | |
|---|---|---|---|---|---|---|---|
| | | Example 7 | | Example 8 | | Example 9 | |
| 2 | Grain size/Number of intersections um/point | 100 | 10 | 100 | 10 | 300 | 3 |
| 3 | | 65 | 15 | 50 | 20 | 75 | 13 |
| 1 | | 35 | 29 | 25 | 40 | 45 | 22 |

**[Table 4]**

| Position | Cooling rate °C/min | 1 | | | | | |
|---|---|---|---|---|---|---|---|
| | | Comparative Example 1 | | Comparative Example 2 | | Comparative Example 3 | |
| 2 | Grain size/Number of intersections um/point | 300 | 500 | 500 | 2 | 300 | 3 |
| 3 | | 300 | 500 | 500 | 2 | 200 | 5 |
| 1 | | 300 | 500 | 500 | 2 | 150 | 7 |

Subsequently, the semiconductor device substrates according to Examples 1 to 9 and Comparative Examples 1 to 3 were subjected to a hot-cold cycle test. That is, 3000 cycles of temperature increase and temperature decrease were repeated between - 40°C and 175°C, then an ultrasonic flaw detection test was performed, and peeling of an end portion of the copper plate was checked. In the ultrasonic flaw detection test, an inspection was performed by a reflection method using an ultrasonic flaw detector FSesIII manufactured by Hitachi Power Solutions Co., Ltd. The results are as follows, and those in which peeling could not be confirmed were evaluated as OK, and those in which peeling could not be confirmed were evaluated as NO. In the image obtained by the ultrasonic flaw detection test, a gap is generated between the copper plate and the bonding layer at the place where the peeling has occurred, and the gap appears white. Thus, the peeling can be confirmed.

**[Table 5]**

| | Results of hot-cold cycle test |
|---|---|
| Example 1 | OK |
| Example 2 | OK |
| Example 3 | OK |
| Example 4 | OK |
| Example 5 | OK |
| Example 6 | OK |
| Example 7 | OK |
| Example 8 | OK |
| Example 9 | OK |
| Comparative Example 1 | NG |
| Comparative Example 2 | NG |
| Comparative Example 3 | NG |

From the results in Table 5, it was confirmed that the copper plate was not peeled off in the hot-cold cycle test when the copper plate had a region in which the average crystal grain size of copper increased as the distance from the interface between the copper plate and the bonding layer increased. On the other hand, in Comparative Examples 1 and 2, the average crystal grain size was the same regardless of the position from the interface. In Comparative Example 3, the average crystal grain size of copper increased as the distance from the interface increased, but the average crystal grain size at the first position exceeded 100 µm. Thus, in Comparative Examples 1 to 3, peeling of the copper plate occurred. Therefore, it was found that when the copper plate has the gradient of the average crystal grain size as described above, and the average crystal grain size at the first position is less than 100 µm, peeling of the copper plate can be suppressed.

### Reference Signs List

2 Semiconductor device substrate
3 Ceramic substrate
4, 4' Copper plate
9 Bonding layer

## Claims

1. A semiconductor device substrate comprising:
a ceramic substrate including a first surface and a second surface;
a bonding layer disposed on the first surface and the second surface; and
a copper plate disposed on the bonding layer,
wherein
the copper plate has a thickness of 0.3 mm or more, and
the copper plate has a region in which an average crystal grain size of copper increases as a distance from an interface between the bonding layer and the copper plate increases, in which the average crystal grain size of copper at a first position separated from the interface by 20 µm is 25 µm or more and less than 100 µm, and the average crystal grain size of copper at a second position separated from the interface by 250 µm is 100 µm or more.

2. The semiconductor device substrate according to claim 1, wherein, in the copper plate, the average crystal grain size of copper at the second position is 100 µm or more and 600 µm or less.

3. The semiconductor device substrate according to claim 1 or 2, wherein, in the copper plate, the average crystal grain size of copper at a third position separated from the interface by 100 µm is 50 µm or more and less than 150 µm.

4. The semiconductor device substrate according to claim 1 or 2, wherein the copper plate is formed of oxygen-free copper.

5. A method for producing a semiconductor device substrate, the method comprising:
a first step of preparing a ceramic substrate including a first surface and a second surface;
a second step of forming a brazing material layer on the first surface and the second surface;
a third step of disposing a copper plate on the brazing material layer to obtain an intermediate product including the ceramic substrate, the brazing material layer, and the copper plate; and
a fourth step of disposing the intermediate product in a furnace and performing a heating and pressurizing treatment,
wherein, in the fourth step, after a temperature of the intermediate product is increased to 800 to 900°C, the intermediate product is cooled to a softening point of copper constituting the copper plate at a first average cooling rate of 2.8 to 12°C/min.

6. The method for producing a semiconductor device substrate according to claim 5, wherein, in the fourth step, after the intermediate product is cooled to the softening point, the intermediate product is cooled at a second average cooling rate lower than the first average cooling rate.

7. The method for producing a semiconductor device substrate according to claim 5 or 6, wherein, in the fourth step, a pressure in the heating and pressurizing treatment is 0.2 to 22 MPa.

8. The method for producing a semiconductor device substrate according to claim 5 or 6, wherein cooling is performed in an inert gas atmosphere in at least a part of the fourth step.

9. The method for producing a semiconductor device substrate according to claim 5 or 6, wherein the copper plate is formed of oxygen-free copper.
